(19)

Europäisches
Patentamt
European
Patent Office
Office européen
des brevets

(11) **EP 3 118 816 A1**

(12) **EUROPEAN PATENT APPLICATION**

(43) Date of publication:
**18.01.2017 Bulletin 2017/03**

(51) Int Cl.:
**G06T 17/20** (2006.01)

(21) Application number: **16178091.1**

(22) Date of filing: **06.07.2016**

| | |
|---|---|
| (84) Designated Contracting States:<br>**AL AT BE BG CH CY CZ DE DK EE ES FI FR GB GR HR HU IE IS IT LI LT LU LV MC MK MT NL NO PL PT RO RS SE SI SK SM TR**<br>Designated Extension States:<br>**BA ME**<br>Designated Validation States:<br>**MA MD**<br><br>(30) Priority: **13.07.2015 GB 201512169**<br><br>(71) Applicant: **Rolls-Royce plc**<br>**London SW1E 6AT (GB)**<br><br>(72) Inventors:<br>• **Lim, Chi Wan**<br>  **Derby, Derbyshire DE24 8BJ (GB)** | • **Yin, Xiaofeng**<br>  **Derby, Derbyshire DE24 8BJ (GB)**<br>• **Zhang, Tianyou**<br>  **Derby, Derbyshire DE24 8BJ (GB)**<br>• **Su, Yi**<br>  **Derby, Derbyshire DE24 8BJ (GB)**<br>• **Goh, Chi Keong**<br>  **Derby, Derbyshire DE24 8BJ (GB)**<br>• **Shahpar, Shahrokh**<br>  **Derby, Derbyshire DE24 8BJ (GB)**<br>• **Moreno, Alejandro**<br>  **Derby, Derbyshire DE24 8BJ (GB)**<br><br>(74) Representative: **Rolls-Royce plc**<br>**Intellectual Property Dept SinA-48**<br>**PO Box 31**<br>**Derby DE24 8BJ (GB)** |

(54) **COMPUTATIONAL MODELLING FOR ENGINEERING ANALYSIS**

(57) This invention concerns a computational engineering modelling tool (10) having a point generation module (12) arranged to read geometry data representing a domain (24) to be modelled. The point generation module (12) also generates point data for the domain having multiple boundary points (26) located on a boundary of the domain and multiple further points (28) spaced from the boundary within the domain (24). A point mutation module (14) processes the point generation module (12) output and generates automatically a plurality of alternative point data definitions for the domain in which the location of at least one point differs between each of the alternative point definitions. A blocking module (16) discretizes the domain (24) by creating multiple geometric blocks over the domain using a computational geometric operator such that each point (26, 28) represents a vertex of at least one block. The blocking module outputs a discretized computational model of the domain (24) and the tool scores the discretized computational model according to a geometric attribute of the blocks.

FIG. 2

**EP 3 118 816 A1**

**Description**

**BACKGROUND OF THE INVENTION**

This disclosure concerns computational modelling tools and techniques, particularly techniques for structuring a model of a domain of interest such that the model can facilitate an engineering analysis of the domain of interest, e.g. including a product/design.

Known computational techniques for analysing engineering behaviour of solid or fluid phase materials include Computational Fluid Dynamics (CFD) and Finite Element Analysis (FEA). Whilst those techniques differ in terms of being volume/element approaches and in the equations used to represent the system behaviour, they share in common a need to apply a mesh to the domain of interest so as to discretize the domain, i.e. to define a suitable array of points/cells over the domain for which calculations can be performed. For CFD applications, conservation of mass, energy and momentum equations are applied to each individual cell in order to determine the flow for the domain as a whole.

However the process of discretizing/meshing a domain is an important consideration since the quality of mesh will impact the quality of the results of the modelling process. For example the density of the cells needs to be carefully considered in regions where the flow is undergoing change so as to adequately capture the relevant flow phenomena. Not only is the cell size/density an important consideration, but also the geometric shape of the cells. It is also to be borne in mind that increasing number of cells used will also increase computational cost, thereby taking more processing power and/or longer processing time to arrive at a solution. This can be particularly problematic where it is necessary to repeat simulations, changing one or more parameters so as to determine the impact on the system behaviour.

Structured mesh generation has traditionally been the preferred form of mesh generation for turbomachinery CFD applications. For aerodynamic analysis, it is generally accepted that structured meshes provide greater accuracy and efficiency compared to unstructured meshes. In addition, structured meshes provide the ability to align with the flow, as well as allow for easier implementation of higher order numerical schemes. However the application of structured meshing is restricted to topologically simple geometries. Consequently, the generation of structured mesh for an arbitrarily-shaped object is divided into two stages: the first stage involves a blocking process of decomposing the object into well-shaped blocks suitable for structured meshing, while the second stage involves the generation of the mesh for each of the blocks.

For many years, the blocking process has generally been performed manually. Current attempts at semi-automation of blocking strategies are mainly based on template matching and any deviation from the predefined topology will require user intervention to define the block layout. This is a time consuming process and for complex geometries, it can take an experienced engineer weeks or even months to complete. Moreover, block quality is greatly dependent on domain knowledge and experience. The quality of blocks generated is a very subjective matter and it is possible for multiple optimal block layouts to exist.

In order to advance the use of structured meshes, there is a general need to automate the blocking process and thereby the meshing/modelling process to a greater extent. Whilst some attempts to achieve automated blocking/meshing have been previously disclosed in the art, the robustness of such approaches have been questionable. Heuristics used in prior art modelling tools make certain assumptions and incorporate rules-of-the-thumb which may not be valid in all situations. For some more complex geometries, prior processes have failed to product optimal or even workable blocking. In particular, if very thin blocks or leading edges are produced then the quality of the resulting mesh will be poor.

Furthermore there exists added complication when extending 2D blocking techniques to 3D domains.

It may be considered an aim of this disclosure to provide techniques and tools for automating computational modelling domain discretization in a more robust and/or automated fashion.

**BRIEF SUMMARY OF THE INVENTION**

According to a first aspect of the invention there is provided a computational engineering modelling tool comprising a point generation module arranged to read geometry data representing a domain to be modelled and to generate point data for said domain comprising a plurality of boundary points located on a boundary of the domain to be modelled and a plurality of further points spaced from the boundary within the domain, a point mutation module arranged to process the point generation module output and to generate automatically a plurality of alternative point data definitions for said domain in which the location of at least one point differs between each of said alternative point definitions, and a blocking module arranged to discretize said domain by creating multiple geometric blocks over said domain using a computational geometric operator such that each point represents a vertex of at least one block, the blocking module outputting a discretized computational model of said domain, wherein the tool scores the discretized computational model according to a geometric attribute of the blocks.

The domain may represent a fluid or solid body of material and the boundary may represent an extremity of said body, for example comprising any or any combination of a solid boundary wall, an interface, an inlet and/or outlet for said body. The boundary may represent the extent of a region of interest within said domain, which may comprise a portion of, or the entire, domain.

The discretized computation model of said domain may comprise a mesh or block structure in which each point is connected to a plurality of adjacent points. The geometric blocks may each be closed geometric blocks and/or each element of the mesh may comprise a closed cell. Triangular or quadrilateral blocks/cells may be used. A quadrilateral mesh may be output over the entire domain.

Each further point may represent a common vertex of a plurality of blocks, typically a common vertex of at least three or four blocks. Said further points may comprise internal points within the domain or a region of interest therein.

All the blocks created by the blocking modules may be used in the scoring process.

Selection of a discretized computational model may be based on the score applied by the tool. The selection and/or output of the discretized computational model by the tool may be automated.

The proposed auto-blocking technique used according to the invention may be considered to comprise a combination of: an evolutionary/point mutation process that allows the tool to discard less optimal point definitions of the domain; and, computational geometry techniques to solve auto-blocking of a domain in a quantitative manner. This type of approach has not been hitherto used to address the problems associated with prior art blocking techniques.

A directed mutation algorithm may be implemented, e.g. that is bespoke to the auto-blocking problem. A mutation operator may allow for the addition and/or deletion of boundary/further points, e.g. while conforming to one or more constraint of the blocking module, such as for example maintaining an even number of boundary points. Test results have shown that this directed mutation approach is able to accelerate the evolution from a non-optimal starting point definition towards better solutions.

The point generation module may be arranged to identify a plurality of sections of the geometry and/or domain boundary. Each section may comprise a straight line or curve. The point generation module may be arranged to identify suitable candidate point locations at a location part way along a section, e.g. according to one or more break point definition/algorithm. A plurality of break point definitions/algorithms may be used.

The point generation module may or may not insert a point at a location where a section is found to create an acute angle in the boundary. The point generation module may or may not insert a point at a location where a curvature value of the boundary is greater than a threshold value. The point generation module may determine the perpendicular components of the distance between a pair of existing points on the boundary. The point generation module may or may not insert a point at a location where one perpendicular distance exceeds a threshold value. The threshold value may be a relative value, e.g. a value relative to a perpendicular component of distance between two other existing points, e.g. another pair of points for which each of the other pair is adjacent one of the first pair.

The point generation module may insert one or more points according to the trajectory of a ray emanating from an existing point. A plurality of ray trajectories may be analysed from a single existing point, for example at angular increments about the existing point. A boundary point may be inserted where a ray meets a location on the boundary. A further point may be inserted according a predetermined fraction of the distance between the existing point and the location at which the ray meets the boundary. The ray may be reflected at least once off the boundary in order to determine a location where the ray meets an opposing portion of the boundary. A boundary or further point may be inserted for the trajectory of reflected ray. This ray-projection technique has been found to be effective in the reduction of computational time required for the search for potentially good points for use in generation of blocking solutions.

The point generation module and/or point mutation module may output a plurality of candidate point data sets, each set providing a different point definition of the domain geometry, e.g. according to the number and/or relative locations/spacing of points within the set. A predetermined number of candidate point data sets may be maintained in the data store. The tool may decide whether to discard a new point data set or else replace an existing candidate data set with the new point data set according to its score.

The sets of points generated by the point generation module and/or mutation module may be ranked/scored, e.g. at the time of scoring the discretized computational model, or else separately. Point mutation may be performed only for point data sets meeting one or more acceptance criterion. A set of points that does not meet one or more acceptance criteria may be removed/deleted. A set of points meeting the one or more acceptance criteria may be logged in a data store. A set of points may comprise a combination of the boundary points and the further points.

Point mutation may be performed by addition and/or removal of one or more point from a data set output by the point generation module. A plurality of point mutation processes may or may not be run in parallel. A plurality of different types of point mutation may be applied to a point data set, e.g. so as to create a corresponding plurality of mutated instances of the data set. Three or four or more mutation schemes may be run.

Point mutation may comprise assessing a geometric attribute of the blocks created for the domain and adding or removing a point from one or more block according to said attribute. One or more point may be added to or removed from one or more point data set according to a block length ratio value or block internal angle value/score.

The point mutation module may comprise either or both of a targeted mutation algorithm and/or a random mutation algorithm.

The point mutation module may comprise statistical/probability based selection operation. The likelihood of selection of a point data set may correspond to its score/ranking. The point mutation module may apply a point mutation process to a selected point data set.

The point mutation module may comprise a point data set crossover/substitution operator or algorithm. The point mutation module may exchange/substitute a portion of a first point data set, e.g. a candidate data set, with a portion of a second point data set, e.g. a second candidate data set. The portion exchanged may comprise a corresponding portion of the domain geometry for each data set, e.g. one or more section or chunk comprising a plurality of adjoining blocks.

The point mutation module may randomly select two point data sets from the candidate data sets for the substitution process.

A candidate point data set and/or a candidate point data set store may comprise a record of candidate point locations proposed by the point generation module but unused in the, or each, candidate point data set.

The point mutation module may comprise a random point insertion/deletion algorithm. Each inserted point may be randomly selected from the candidate points stored in the data store. Each deleted point may be randomly selected form the boundary and/or further points within point data.

Each alternative point definition generated by the point mutation module may be ranked/scored by the tool.

The point data representative of the domain geometry may be stored as a file in a data store. The data store typically comprises a non-volatile data store or memory.

The blocking module may automatically calculate one or more blocking solution for each candidate point data set.

The blocking module may comprise a triangulation module in which triangular blocks are formed, for which each point represents a vertex of each triangle. A constrained triangulation technique may or may not be used, such as, for example Delaunay Triangulation.

The blocking module may comprise a geometric block merging tool. The merging tool may merge adjacent blocks so as to form a different type of polygon from the plurality of merged polygons. The merging process may comprise searching/identifying adjacent geometric blocks that share a common adjoining line/edge. The merging process may comprise deletion of a line/edge contained within the merged geometric shape. Triangular blocks may be merged for example into quadrilateral blocks by deletion of a block interface between two adjacent blocks.

The blocking module may apply a smoothing operation to the generated geometric blocks, e.g. to improve the uniformity of the multiple generated blocks. A gradient-based smoothing operation may be preformed.

The blocking tool may comprise generation of a proposed geometric blocking structure and/or mesh which comprises all the points within the domain, e.g. which spans the entire domain contained within the domain boundary.

The score applied by the tool may comprise a model fitness score. The score may be determined according to a calculation of one or more indicator of asymmetry of the generated geometric blocks. The score may comprise a statistical indicator for the asymmetry measure of all the blocks in the domain or a portion thereof. The asymmetry measure may or may not comprise an absolute or relative internal angle measure of a block, for example an indicator of the deviation of one or more internal angle from a regular internal angle. The asymmetry measure may or may not comprise a ratio of the length of a plurality of sides of a block, e.g. an indicator of block taper.

The discretized computational model may comprise a two-dimensional mesh including a set of boundary points comprised in a boundary shape input to the point generation module.

The tool may advantageously formulate the automation of the blocking process as a multidimensional objective optimization problem, e.g. where the shape of each individual blocks are optimized subject to the set of objectives. The output geometric model may comprise a selected quadrilateral mesh for the domain.

According to a second aspect there is provided a computational modelling method corresponding to the function of the tool of the fist aspect.

According to a third aspect of the invention, there is provided a data carrier comprising machine readable instructions for operation of one or more processor in accordance with the method of the second aspect.

The overview of an example of the proposed auto-blocking solution is as follows. The 2D closed polygonal input boundary may first be pre-processed such that a minimal number of boundary points are used to approximate the shape of the input boundary. Using a novel heuristic approach, this set of minimal boundary points may be used to derive two sets of potential points, one set of exterior/boundary points and one set of interior/further points. An evolutionary/mutation algorithm (EA) may randomly select a subset from both sets and populate a pre-determined number of populations. For each population, the two subsets, together with the set of minimal boundary points, may be used to form a blocking solution using a series of computational geometry techniques. The fitness of the solution may be computed by using the set of objective functions, based for example on angle quality and shape taper of the blocks within the solution.

In any example of the invention, the EA may run for a pre-determined number of generations and the survivability of solutions in each generation may be determined by its fitness score. Each generation may advantageously first ensure the survivability of the best solutions and furthermore use these sets of best/candidate solutions to combine with each other or mutate in other ways in an attempt to form superior solutions. Over the number of generations, the solution set may stabilize/converge and the best solution may thus be obtained.

Wherever practicable, any of the essential or preferable features defined in relation to any one aspect of the invention may be applied to any further aspect. Accordingly the invention may comprise various alternative configurations of the features defined above.

## BRIEF DESCRIPTION OF THE DRAWINGS

Practicable embodiments of the invention are described in further detail below by way of example only with reference to the accompanying drawings, of which:

Fig. 1 shows a schematic of a modelling system according to an example of the invention;

Fig. 2 shows a flow diagram of operational stages in accordance with an example of the invention;

Figs. 3A to 3C show examples of different point/segment definitions for a geometric model of a body 24;

Figs. 4A and 4B show a geometric model of a body subject to two different stages of point generation according to an example of the invention;

Figs. 5A to 5F show a geometric model of a body when subjected to various different evolution/mutation processes according to examples of the invention; and,

Figs. 6 to 8 show examples of quadrilateral meshes generated for different geometric bodies using the point processing and blocking techniques described herein.

## DETAILED DESCRIPTION OF THE INVENTION

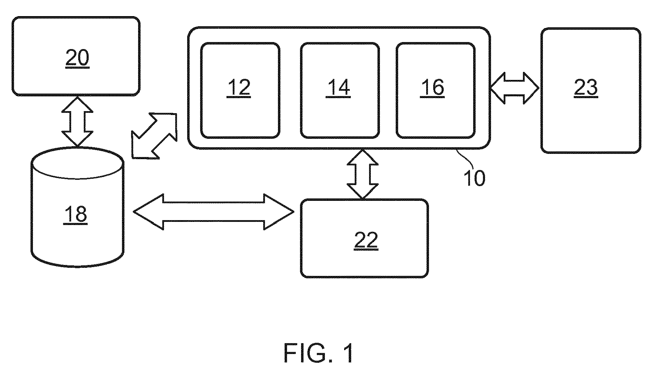

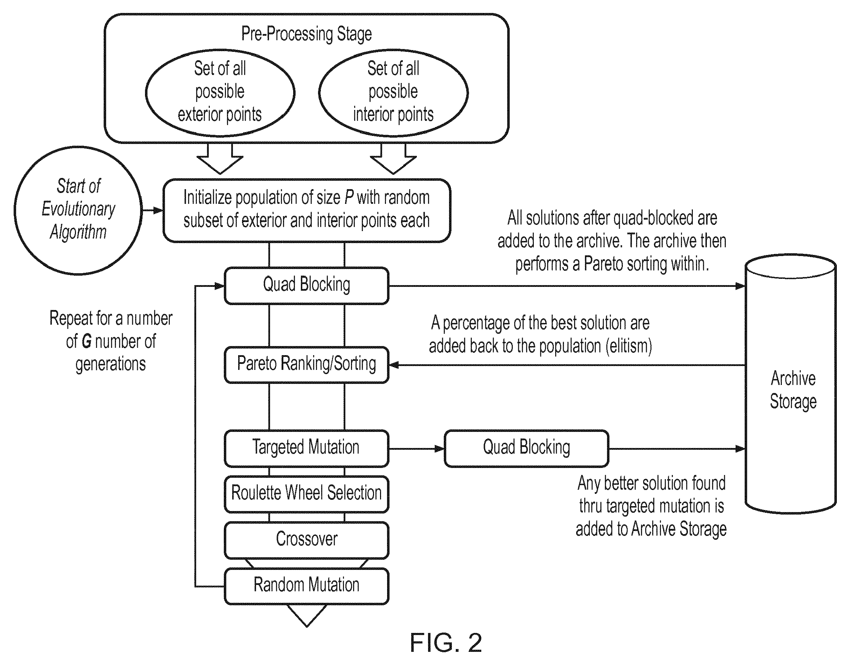

Figs. 1 and 2 show an overview of an auto-blocking system and its operation. The auto-blocking system 10 comprises of three main components, a pre-processing module 12, an evolutionary algorithm (EA) module 14, and a polygonal/polyhedral blocking module 16.

The modules all access one or more data store 18, typically a common data store on which the relevant geometric model data is stored and can be accessed and/or amended by the system 10. The system 10 may receive its input data from a computer aided design (CAD) system/module 20 either directly or from the data store 18. Any other geometry generation software may be used as an input to the system 10, provided it can output geometric data in one or more conventional format in which mathematical point, line/edge and/or surface data is accessible.

A user interface 22, typically comprising - or output t the user via - a display screen allows a user to input one or more control parameter for operation of the system 10 and/or manipulate/modify geometry, e.g. via a visual representation of the domain of study or a portion thereof.

The system 10 can output data to a meshing tool 23, which may comprise a further module of the system 10 or a separate meshing tool in communication with the system, e.g. directly or via data store 18. The system 10 and/or meshing tool 23 may form part of a larger computer aided engineering suite, e.g. residing on one computer/system or else in communication over a local or wide area network. The meshing tool 23 may be in two-way communication with the system 10 such that iterative geometry changes can be made and shared between the two modules. The system 10 and/or meshing tool 23 meshing tool 23 may form part of an engineering modelling tool, such as a CFD or FEA tool.

### Overview

The modules 12, 14, 16 typically operate in series, with the output of one being input to the next, although each individual module 12, 14, 16 may iterate individually or communicate iteratively with its adjacent module without requiring a full iteration through the system 10. The system 10 operation commences with the pre-processing stage in which module 12 takes in a 2D polygonal closed boundary, represented in a series of connected sections or portions, e.g. line data, referred to herein as 'segments'. The objective of this stage is to reduce the 2D polygonal boundary into a set of minimal boundary points. This set of minimal boundary points should contain a sufficient number of points to describe the 2D polygonal boundary input adequately, e.g. whilst being a small as possible.

Using this set of minimal boundary points, a ray-shooting technique is employed to generate two sets of points; a set of all possible exterior points, and a set of all possible interior points. These two sets of points will be used by the EA 14 as inputs for evolution.

In the second main module 14, the EA algorithm takes in the set of minimal boundary points and the sets of all possible exterior and interior points. The two parameters for determining the search space of the EA are **G,** the number of generations, and **P,** the population size. The population size determines the number of solutions that the algorithm holds at each generation and which the various evolutionary operations will be applied on. The number of generation determines how many iterations this process will be run.

At the start of every iteration of the blocking process, each relevant subset of exterior and interior points is combined with its minimal boundary to form a potential/candidate solution using the blocking module 16. The computed solution is added to the archive storage. The set of **P** population is combined with a number of the best solutions from the archive storage (determined by a pre-determined *elitism* ranking/percentage). This combined set of population is put through a *pareto* ranking and sorting process, and trimmed to a size of **P.** A targeted mutation module is then applied as a form of targeted local search towards a more optimal solution. The quad blocking module is applied and any solution found more optimal than its original is added directly to the archive storage. At this point onwards, a series of evolutionary operators is applied upon the population. This process then repeats itself for **G** number of times before outputting a final solution.

## Pre-processing

The input to the auto-blocking algorithm is a 2D polygonal closed boundary, represented in a series of connected segments. Each segment is captured as a series of points, which can represent/define either a straight line segment or a curved segment. The module 12 defines a standardized approach towards the extraction of a minimum set of points that is able to describe the input boundary in a manner that is size invariant. This implies that both large features and small features of the input boundary are represented with equal fidelity. In addition, this section describes the extraction process of the set of all possible exterior and interior points that will be utilized by the evolutionary algorithm

The pre-processing module consists of two main stages: (i) pre-processing of the input boundary; and (ii) the generation of the sets of all possible exterior and interior points.

The input boundary is a series of connected segments, e.g. in which the end of one segment coincides with the start of an adjacent segment, so as to define a closed boundary, e.g. a surface/edge of a body represented as a geometric shape in the domain of interest. However, the density of the representation might not be uniform, i.e. a short straight segment can be represented by a large number of points, while a smooth curved segment may be represented by only a few points. Different datasets might have different sampling density of points along a curved segment. The objective of this stage is to produce a set of minimal boundary points that best approximate the input boundary. In this example, the derived set of minimal boundary points will automatically be included in all solutions produced by the other modules, possibly with additional points selected from the pool of all possible exterior points.

In theory, a solution can be achieved just by using the set of minimal boundary points in later processing stages, albeit with a likelihood that the generated blocks may be poor in quality, depending on the nature of the input geometry to be resolved. Such a solution could already display high fidelity with the original input boundary, due to the approach by which the minimal boundary points are selected.

However, it can be difficult to pin down the optimal number of required points for the set of minimal boundary points. If one bears in mind that the goal of the automatic blocking problem is to create a set of polygonal blocks that covers the entire interior space of the given input boundary, with each block a good candidate for applying meshing of kid corresponding to the type of polygonal block, e.g. quadrilateral mesh structure applied to a 4-sided block. As such, if a solution contains a low number of blocks, each block might not be able to approximate the boundary segment with high fidelity, and if a solution contains a high number of blocks, the fidelity could be improved but the solution search space could be vast and hence impractical for implementation.

Potential input boundary approaches include distance based sampling, error based sampling, and curvature based sampling, each being apt for certain geometries better than others. The approach that was adopted in this example so as to be more holistic consists of three main point-defining stages (e.g. to use three different point/segment identification techniques):

    1. Single large angle breakpoint
    2. Curvature based breakpoint
    3. Bounding box breakpoint

To begin the pre-processing stage, we combine all the connected segments into one contiguous chain of n number of points, which are represented as a set of points, defined as $P = \{p_1....p_n\}$.

**1. Single large angle breakpoint:**

For each point $p_i$, we compute the angle associated with it that is formed by the set of points $\{p_{(i-1\%n)}, p_i, p_{(i+1)\%n}\}$, i.e. where lines drawn from the point to adjacent points form an angle at the point. For any point with an associated acute angle, smaller than 90°, it is used as a breakpoint to split the chain of points into smaller segments. In other examples, the angle threshold may be varied and may for example be set at 120° or 150° depending on the desired results. Assuming that m number of breakpoints exist, represented by the set $B = \{b_1 \dots b_m\}$, segments can be defined as

$$S_i = \begin{cases} \{p_{b_i}, p_{b_i+1}, \dots, p_{b_{i+1}}\} & if \ 1 \leq i < m \\ \{p_{b_i}, p_{b_i+1}, \dots, p_n, p_1, \dots, p_{b_1}\} & if \ i = m \end{cases}$$

$S = \{S_1 \dots S_r\}$, where $n$ is the number of segments.

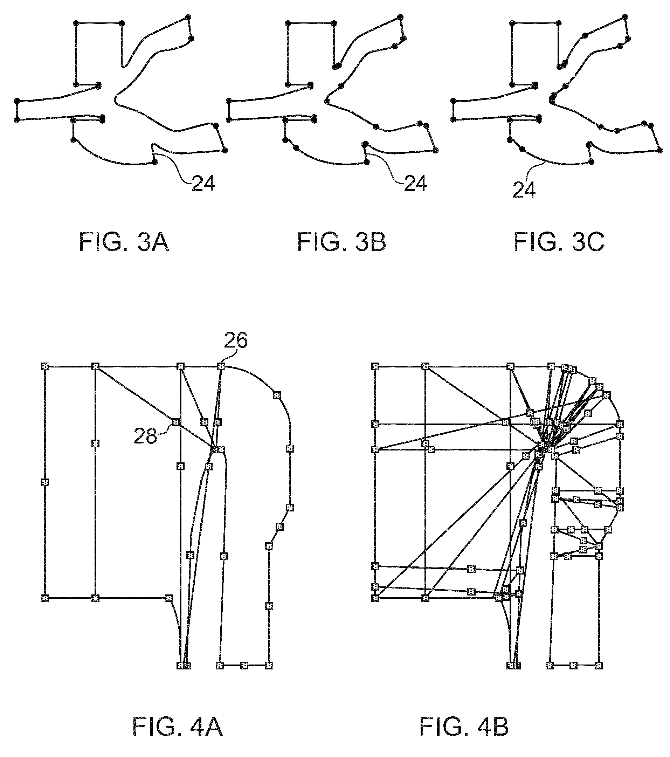

In the example of Fig. 3A it can be seen that the geometric body 24 has been reduced to fifteen line segments, e.g. with a common point adjoining adjacent segments.

**2. Curvature based breakpoint:**

For each segment $S_i$, we proceed to split it further using a curvature based approach. Assuming that $S_i$ consist of m number of points,$\{p_1 \dots ; p_m\}$, we compute the total curvature change

$$Total\ curvature\ change = \sum_{j=2}^{m-1} acute\ angle\left(p_{(j-1)}, p_j, p_{(j+1)}\right)$$

Based on the total curvature change, we can determine the number of interval points to be placed along the segment based on the following equation. Generally, one extra interval point is place for every 90 degrees of curvature change, starting from 45 degrees. The equation used is

$$No\ of\ interval\ points = \left\lceil \frac{total\ angle\ change - 45^o}{90^o} \right\rceil$$

Based on the number of interval points, we can calculate which of the points are the curvature breakpoints using the following pseudo code

Compute **totalCurvatureChange**
Compute **NoOfIntervalPoints**

$$CurvatureInterval = \frac{totalCurvatureChange}{NoOfIntervalPoints}$$

cumulativeCurvature $\rightarrow 0$
breakPointSet = Ø

For **a** = 2 to m - 1

$$cumulativeCurvature\ += acute\ angle\left(p_{(a-1)}, p_a, p_{(a+1)}\right)$$

if ( cumulativeCurvature > curvatureInterval )

Insert a in breakPointSet
cumulativeCurvature -= curvatureInterval

Each index stored in *breakPointSet* is used to split the segment up into smaller segments as can be seen in the example of Fig. 3B, in which the curved sections of the geometric body 24 include one or more intermediate break point, thereby defining smaller segments.

Curvature breakpoints may be important where the curved lines to not form an acute angle breakpoint, but it remains desirous to divide up segments.

### 3. Bounding box breakpoint:

For each smaller segment $S_i$, we proceed to split it further using a recursive bounding box approach. Assuming that $S_i$ consist of $m$ number of points, $\{p_1...., p_m\}$, in order to determine if $S_i$ is required to be split into two smaller segments, we compute the perpendicular distance of points from $p_2$ to $p_{m-1}$ to the line form by $p_1$ and $p_m$. From the set of computed perpendicular distances, we select the largest. If the largest distance is larger than a predetermined fraction, e.g. 0.15, of the distance between $p_1$ and $p_m$, we split $S_i$ at the index where the largest distance occurs. The two child segment that resulted from the separation is then recursively put through the same bounding box test, an example of the results of which is shown in Fig. 3C.

In an idealized case of two straight line meeting at a 90 degree corner that is connected by a perfect quarter circle, a single point placement at the centerpoint of the quarter circle should be sufficient for our needs. In such a setting, the two resulting boxes created after the placement of the centerpoint should not be exceeding 0.15 on either side, no matter the length of the two straight lines. Whilst the specific figure of 0.15 has been selected here as being suitable for general application, this figure could be varied if desired, for example between 0.1 and 0.3, although a wider range could be considered if only specific geometry types are required to be analysed by the system 10

The three successive figures from left to right Fig. 3 thus show the computed breakpoints for an input dataset representing a cowl structure using the (A) single large angle, (B) curvature based, and (C) bounding box approaches, cumulatively. The resulting segment definitions in this example are thus taken from the line segments between the points of Fig. 3C.

The guiding principle in the generation of the pool of all-possible interior and exterior points is based on the question: "for a point located within the set of minimal boundary points, if it were to form an edge with an exterior or interior point, where would be a good location for that exterior or interior point?" The formed edge will be adjacent to two blocks and is bound to affect both the taper and angle quality of both blocks. Thus, for each point in the set of minimal boundary points, we locate a set of potential exterior and interior points.

### Generation of pool of all possible exterior and interior points:

The above point defining techniques are used to define a minimum point set. Further potential points are generated to increase the size of the set. For the generation of the pool of all exterior points, the following pseudo code is used:

*For every point **x** in the set of minimal boundary points*

*Compute interior angle **y** (in degrees) at point **x***
*For **a** = 60; **a** < **y**- 60; per step increase perform the following (i.e. **a** += interval step)*

> *1. Shoot a ray with at point **x** equal with an angle equal to **a**, the first intersection with input boundary is a **potential exterior point***
> 2. *At one-third of the distance of this ray, this is a **potential interior point***
> 3. At the point of ray intersection with the input boundary, reflect the ray one more time (using the internal midpoint angle at that point). The intersection of this second ray with the boundary is a ***potential exterior point.***
> 4. *At one-third of the distance of this second ray, this is a **potential interior point***

The variable interval step is employed to control the number of potential exterior points that are generated. A value of 20 degrees is used in this example of implementation, although it will be appreciated that this could be altered in other examples. It will be appreciated that the interior/exterior points are defined only where the ray intersects with a boundary of the geometry, i.e. with one or more line/segment of the model.

Fig. 4 shows an example of exterior and interior point generation for the geometry of a section through a gas/air intake. The image of the dataset in Fig. 4A shows the first and secondary ray emanating out from point A, and the resultant intersection of the ray with the boundary is marked as a potential exterior point 26, while for every ray at one-third of the distance is marked as a potential interior point 28. In Fig. 4B, the process is repeated for the other points at the internal corner at A.

The result of this placement strategy is efficient for exterior point placement, since all possible exterior points can be linked to a fixed exterior point on the set of minimal boundary point. The rationale for a secondary ray emanating from the first intersected location is for cases where the first intersected location might be located in isolation with no nearby exterior points to form good blocks. By using a secondary ray, more options are available for forming good blocks.

The case for interior point selection is directly linked to placement of exterior points. For every possible exterior point, a potential option for an interior point in an optimal position is available. However, in cases where the ray covers a relatively long distance, a midpoint placement might be too far for the exterior point. This is the reason where a one-third distance placement option is adopted.. As with the angle increments, the location of the internal point along the ray length could also be adjusted if desired, but is preferably less than half the distance of the ray away from the initiating point.

The set of all possible exterior and interior points is used as the source upon which EA draws to merge with the set of minimal boundary points to derive a possible blocking solution. From this viewpoint, these two sets of points can be deemed to dictate the search space in which EA operates. Hence, it is important these two set of points be kept as small as possible in order not to unnecessarily expand the search space. Each point that resides in these two sets should therefore be selected based on its potential to form, e.g. quadrilateral, blocks of good quality, both in terms of angles and shape.

## Evolutionary Algorithm

When the auto-blocking algorithm begins, a population of size $P$ is set up. Each individual population randomly selects a subset of both exterior and interior points from the pool of all possible exterior and interior points. Each population, with the selected exterior and interior point, is fed into the blocking module 16 (described in detail below) where a blocking solution is generated, together with a fitness score representation of that blocking solution.

At the same time, an archive storage holding a population size of 3*$P$ is also set up. After all the population are sent to the quad blocking stage, all completed blocking solutions are added into the archive storage. They will undergo a Pareto ranking (described below) and only a predetermined number (e.g. 3 x $P$) of the best blocking solutions are kept within it.

A pre-determined number of the best solutions *(elitism ratio)* within the archive storage are then injected back into the population, and trimmed back to a size of $P$ using Pareto ranking, in order to ensure the constant survival of the best solutions discovered so far.

## Targeted Mutation

Once the population set goes through the quad blocking module and the blocking solution obtained, the Pareto ranking operation sorts the population, based on a 2-dimensional objective function. Each population is given a Pareto rank. All the population solutions with rank 0s are deemed to be the best solutions, with none better than any of them. Before the evolutionary operators are applied onto the population set, a targeted mutation operation is first applied. The targeted mutation operator can be seen as a local search operation, whereby, based on a set of next-best possible changes, an exhaustive search is conducted to derive a better solution.

There four possible targeted mutation schemes, any or any combination of which may be used: (1) best place to insert exterior point; (2) best exterior point to remove; (3) best place to insert interior point; and (4) best interior point to remove. At the end of each blocking operation, a blocking solution is generated. A blocking solution is a set of polygon that completely encompasses the interior boundary of the given input. In this example, at the end of the blocking operation for each population solution, a list for each adopted targeted mutation scheme is generated - i.e. leading to four lists if schemes (1)-(4) are used.

1. Best location to insert a new exterior point

- We first locate all the quadrilaterals that are adjacent to the boundary. For each quadrilateral, find the ratio of the length of the edge lying on the boundary to its opposite edge. The midpoint of the boundary edge with the highest ratio is the best place to insert a new exterior point. A list is generated containing the midpoints, ranked according to the associated quadrilaterals with the highest ratio first.

2. Best exterior point to be removed

- Each exterior point is adjacent to two quadrilaterals that are adjacent to the boundary. The ratios (length of edge on boundary to opposite edge) of both quadrilaterals are added up and used to rank each exterior point, with the exterior point with the lowest summed ratios first in the list.

3. Best location to insert a new interior point

- All quadrilaterals are ranked based on their internal angle quality (as described further below). The midpoint of the quadrilateral with the worse angle quality is deemed to be best location to insert a new interior point. A list is generated containing the midpoints, ranked according to the associated quadrilaterals with the worse angle quality first.

4. Best interior point to be removed

- Each interior point is adjacent to a number of quadrilaterals. The combined angle qualities for all adjacent quadrilaterals to an interior point is combined and used for ranking. A list is generated with the interior point with the highest combined value (worse angle quality) is ranked first, as this is the best interior point to be removed.

In this example, the targeted mutation scheme is applied only to the Pareto rank 0 solutions. This is, at least in part, because the operation itself is a relative computationally expensive; hence it might be prudent to only apply it to a selective group that might yield potential benefits. Also, a successful targeted mutation generally only provides a slight improvement in terms of the objective function. Applying it to the higher ranked solution might not yield solutions that are better than the rank 0s in any case.

To apply the targeted mutation operation, each rank 0 solution is duplicated to provide four different instances. For each instance, a different targeted mutation scheme is applied. For the 1st scheme (best location to insert a new exterior point), the first location value off the first list in the solution is taken. Using this location, we search for the nearest exterior point from the pool of all possible exterior point that is currently not in use by the solution. This nearest exterior point is then added to the solution. This operation is repeated twice, i.e. referring to the list twice, e.g. to maintain evenness in the number of exterior points.

For the 2nd scheme (best exterior point to be removed), the first and second exterior point stored in the list are simply removed from the current solution.

For the 3rd scheme (best location to insert a new interior point), the first location value is selected from the first list in the solution. Using this location, the nearest interior point is searched for from the pool of all possible interior points currently not in use by the solution. This nearest interior point is then added to the solution.

For the 4th scheme (best interior point to be removed), the first interior point stored in the list is simply removed from the current solution.

Each duplicated instance is run through the blocking module 16. If the duplicated solution generates a better solution, the solution is logged in the archive storage. To determine if a solution is better, we use the following function:

$$Mutation\ improvement = \frac{new\ angle\ quality}{original\ angle\ quality} + \frac{new\ taper\ ratio}{original\ taper\ ratio} < 2.0 \rightarrow better\ solution$$

**Evolutionary Operations**

There are three evolutionary operations that are included in the EA approach in this example, although different aspects of the invention could use any one operation, or two or more in combination. A statistical/probability based selection operation is designed to duplicate good solutions within the population, at the expense of the bad solutions. A crossover operation randomly selects two of the solutions within the population, and exchanges part of their exterior and interior points with each other to form two new child solutions. A guided mutation makes use of the available meshing information to strategically place new points or remove points from the current blocking solution.

The probability selection approach, termed the 'roulette wheel' selection, is used to sieve out the bad solutions from the population. The population is first sorted based on each solution's Pareto rank. Within the same Pareto rank, the solutions are further sorted based on its angle quality measure. Once the population is sorted from $S_1$ to $S_P$, each solution is assigned a probability based on the following function

$$Probability(S_a) = \frac{a}{\sum_{i=1}^{P} i}$$

Based on these probabilities values, a random number generator is called **P** number of times to re-populate the population. Good solutions will tend to be selected more than once, while bad solution will have a lower chance of being selected again into the population.

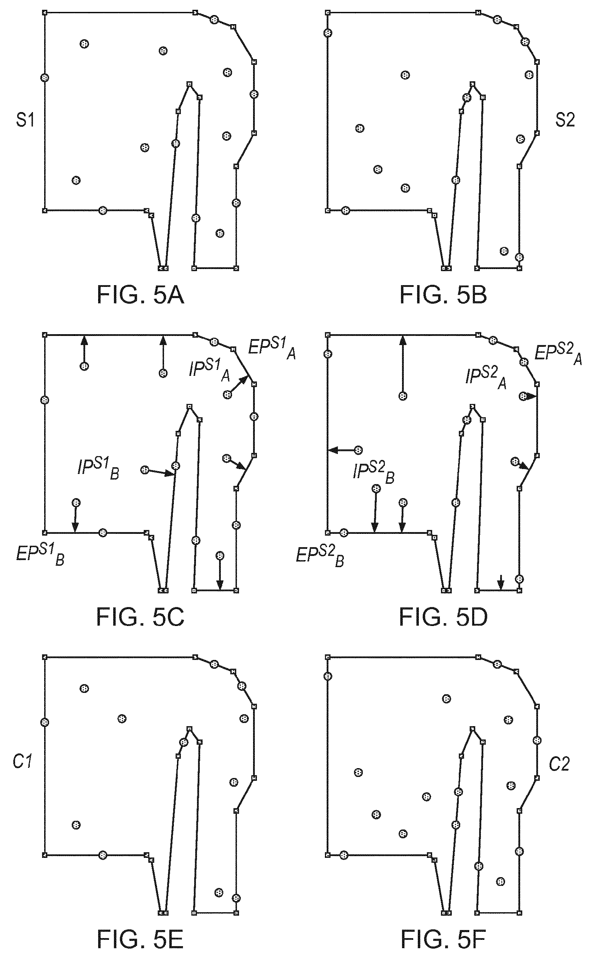

The idea of crossover is to merge two solutions, **S1** and **S2** (e.g. as shown in Figs. 5A and 5B), together to obtain two new child solutions, **C1** and **C2**, with each child solution resembling part of its two parent solutions. To achieve this objective, we first select two points on the boundary which splits the boundary into two distinct portions, **A** and **B**, shown as purple and orange outlines in the example of Figs. 5C and 5D. For **S1**, the set of exterior points **EP$^{S1}$** can be cleanly split into **EP$^{S}_A$** and **EP$^{S1}_B$**, depending on which boundary portion **A** or **B** the exterior point is lying on. For interior points **IP$^{S1}$**, we can traverse the interior edges to determine the shortest part of each interior point to the boundary. Depending on the end of the shortest path lying on boundary portion **A** or **B**, **IP$^{S1}$** can also be split into **IP$^{S1}_A$** and **IP$^{S1}_B$** (see Figs 5E and 5F). Hence for **C1** and **C2**,

$$EP^{C1} = EP^{S1}_A + EP^{S2}_B$$

$$IP^{C1} = IP^{S1}_A + IP^{S2}_B$$

$$EP^{C2} = EP^{S1}_B + EP^{S2}_A$$

$$IP^{C2} = IP^{S1}_B + IP^{S2}_A$$

The random mutation evolutionary operator is applied separately to both the interior points and the exterior points. For interior points, the random mutation operator randomly selects one of the following operator: 1) do nothing; 2) randomly select an existing interior point to delete; 3) randomly select an unused interior point from the pool of all possible interior point to insert.

For exterior points, the random mutation operator randomly selects one of the following operators: 1) do nothing; 2) randomly select a pair of existing interior point to delete; 3) randomly select a pair of unused exterior points from the pool of all possible exterior point to insert.

**Block Generation Module**

The input to the block generation module is the input boundary together with a set of exterior and interior points. The block generation module 16 creates a blocking solution blocks and calculates a fitness score for that solution.

The generation of a blocking solution can be briefly condensed into four major steps: insertion of exterior and interior points with the set of minimal boundary points; constrained Delaunay triangulation of all points; quad mesh generation; and, lastly, mesh smoothing. The two-dimensional fitness score of the blocking solution depends therefore on how well formed the quad mesh are, which may in turn depend on how well a triangle mesh has been formed as will be described below. Since the input boundary is fixed, a good quality constrained Delaunay triangle mesh is dependent on the selection of the additional interior and exterior points that are inserted into the input boundary.

The fitness score in this example is determined based on geometric properties of the blocks/mesh produced, for example including block taper and angle quality. The fitness score may assess the departure of blocks from an equilateral/regular block, e.g. where a greater taper of the block or greater variation in interior angle causes a reduced fitness score. The module may assess the statistical distribution of the block parameters used in generating the solution and/or the number of blocks for which one or more block parameter is outside of a predetermined threshold.

For the purpose of scoring a solution, each quadrilateral element in the quadrilateral mesh is considered to be one single block in the blocking solution. In this example, there are two main fitness score related to each quadrilateral element, one is related to the taper of the element, and the other is the associated angle quality of the internal angles of the element. Assuming that $v_1$, $v_2$, $v_3$, $v_4$ are the four vertices of a quadrilateral element and $\theta_1$, $\theta_2$, $\theta_3$, $\theta_4$ are the associated internal angles; the taper of the element is defined as maximum ratio of lengths derived from opposite edges,

$$Taper\ of\ a\ quadrilateral\ element\ =\ max\left\{\frac{\|v_1 - v_2\|}{\|v_3 - v_4\|}, \frac{\|v_3 - v_4\|}{\|v_1 - v_2\|}, \frac{\|v_2 - v_3\|}{\|v_4 - v_1\|}, \frac{\|v_4 - v_1\|}{\|v_2 - v_3\|}\right\}$$

The angle quality of a quadrilateral element is defined as

$$Angle\ Quality\ of\ a\ quadrilateral\ element = \sum_{i=1}^{4} (\theta_i - 90)^2$$

Once the taper and angle quality of each quadrilateral element is computed, the fitness score of the blocking solution can be derived accordingly. A simple computation approach is to take the average taper and angle quality of all the quadrilateral elements within the blocking solution. However, this approach favours solutions that contain a lot of quadrilateral elements which tends to bring down the average value. On the other end of the spectrum, using the worse element in terms of taper and angle quality as a representation of the fitness score of the blocking solution unfairly penalises solutions with only very few bad elements. A comfortable compromise is achieved by taking the worse 10% elements in both categories as a representation of the fitness score of the blocking solution.

The block generation module 16 generally comprises of the following procedures/routines:

- Constrained Delaunay Triangulation of all points
- Triangle Mesh Based Smoothing
- Triangle to Quad Mesh Conversion
- Quad Mesh Based Smoothing
- Gradient Based Optimization Smoothing

A constrained Delaunay triangulation of the input boundary, together with the input set of exterior and interior points is created. The constrained edges are the input boundary, together with the set of exterior points.

A triangle mesh smoothing operation is applied to all the interior points in order to form a mesh with better angle quality. The smoothing algorithm that is applied is the angle-based smoothing approach, a summary of the which is as follows:

*For each interior point **p**,*

*extract the set of n points that have an edge connectivity with it, {$v_1$ ... $v_n$}.*

*For a = 1 to n*

*compute $\delta_{a1}$ and $\delta_{a2}$, where $\delta_{a1}$ is the angle formed by **p**, $v_a$, $v_{a-1}$ and $\delta_{a2}$ is the angle formed by **p**, $v_a$, $v_{a+1}$*

*Rotate the vector **p**-$v_a$ by an angle of ($\delta_{a1}$-$\delta_{a2}$/2) to get the point $p_a$*

*Take the combined average position of $p_1$ to $p_a$ to be the new position of **p***

In the conversion of the triangle mesh to a quadrilateral mesh, pairs of adjacent triangle elements are merged together to form one quadrilateral element. In this regards, a constraint of an even number of triangle elements is enforced to ensure a successful conversion. Euler formula suggests that if there is an even number of points on the boundary, there will exists an even number of internal triangles, independent of the number of interior vertices. Hence, during the constrained Delaunay triangulation process, if the number of boundary points (input boundary + exterior points) is not even, a random exterior point is discarded in order to maintain the evenness of the number of triangles. The general algorithm for the triangle to quadrilateral mesh conversion is as follows:

Do

{*Repeat merge_ isolated_triangle() until isolated_triangles = 0*}

*while (add_best_pair() == true)*

The variable *isolated_triangles* tracks the number of isolated triangles currently in the mesh. An isolated triangle is defined as a triangle with only one or less adjacent triangle, which occurs when more and more triangles pair are merged together to form quadrilaterals. The algorithm repeatedly merges all isolated triangles with their only adjacent triangle neighbour, if any, in the function *merge_solated_triangle()*. When there are no more isolated triangles left, the algorithm searches for all non-border edges that have a triangle element on both sides of it in the function *add_best_pair()*. The angle quality of the potential quadrilateral formed by the triangle elements on both sides of the edge is computed and stored. The edge that forms the quadrilateral element with the lowest angle quality measure is then selected and that quadrilateral element is then subsequently formed. The algorithm then goes back to search for isolated triangles to merge again. This process repeats until there are no more triangles that can be merged, i.e. isolated triangles with no triangle neighbours.

Given that there is an even number of triangles elements to start off with, there will be an even number of isolated triangles left, if there exist any. To merge pairs of these isolated triangles together, the algorithm adopts the following procedure:

*Take a random pair of isolated triangles **x** and **y***

*Search for a connected chain of quadrilateral **Q** = {$Q_1$...$Q_n$} between **x** and **y***

*While $Q$ != Ø*
*Merge the last quadrilateral $Q_n$ with y to form a pentagon p*
*Divide $p$ into a triangle $y'$ and quadrilateral $Q'_n$ such that $y'$ is adjacent to $Q_{n-1}$ (or $x$ if n==1) Remove $Q_n$ from $Q$*
*Let $y=y'$*
*Merge $x$ and $y$ together to form new quadrilateral element*

The algorithm runs through another smoothing operation using a similar method to the triangle based smoothing approach, with a slight modification. In the triangle based smoothing approach, the algorithm first extract a set of vertices that have edge connectivity with the point being smoothed. In this version of quad based smoothing, we first gather all the quadrilaterals that are adjacent to point $p$. For each quadrilateral, we ensure that its interior edge of is connected to $p$, otherwise the algorithm proceed to perform edge flipping on the internal edge. The quad based smoothing approach then proceeds in the same manner as the triangle based smoothing approach.

In both the smoothing operations that are applied previously, the objective is to form good quality meshes as much as possible. However that does not necessarily lead to the final quadrilateral meshing having the best possible taper and angle quality fitness score. The reason is due to the quadratic function that is applied to the angle quality function, which penalises the quadrilateral elements more heavily as the interior angles deviates further away from the optimal 90°. Gradient-based smoothing is thus applied. The pseudo code for gradient based optimization smoothing is as follows.

*Repeat for $n$ number of times*
*For each interior point $p$*
*Compute combine angle quality measure of all adjacent quadrilaterals*
*Shift $p$ in four discrete steps (+/- $\delta x$ and +/- $\delta y$), where $\delta$ is a small value*
*Find the discrete $\delta'$ shift that improves the original combine angle quality most*
*$p =p + \delta'$*

Note that the algorithm also applies the gradient based optimization smoothing for exterior points too. However for the case of exterior point, the $\delta$ shift is limited to along the border of the input boundary.

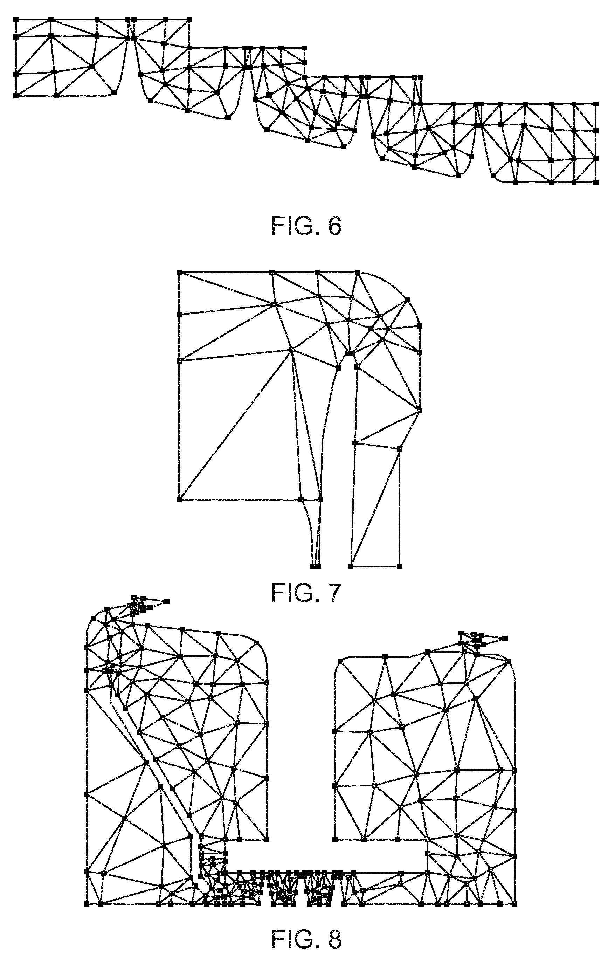

Examples of different meshes formed using the above described approach for different geometry modelling applications are shown in Figs. 6-8, in which the resulting mesh is shown as well as the lines removed during the triangle-to-quad conversion process. The clustering of points and mesh cells more tightly in the areas of greater geometry variation, i.e. to more accurately capture flow phenomenon in those regions is clearly visible.

The above processes described in relation to modules 14 and 16 can be repeated and the output solution assessed using the scoring system described above in order to arrive at a best achieved solution. The processes of blocking and point refinement can be iterated until a solution meets predetermined criteria and/or repeated for a predetermined number iterations or processing time, wherein the best solution found at the expiry of said time/iterations is selected for computational analysis of engineering behaviour of the system using conventional engineering analysis tools. Alternatively, the modules may generate a plurality of blocking/mesh solutions with an indication of the preferred selection according to the Pareto ranking/sorting process. A user may be able to select a solution and/or review alternatives according to mesh visualisation and/or inspection of the parameters used for solution scoring as described above.

The meshing module 23 may or may not be integrated with the blocking module 16 as described above. The meshing tool 23 may take a selected blocking solution and define any additional geometric characteristics and/or mech point/boundary definitions required for computational engineering analysis. The meshing module 23 may also allow user interaction with the output mesh, e.g. visualisation, manipulation and/or manual editing of the mesh. Thus whilst the invention allows automated blocking and mesh generation, it may still permit user expertise to be used to modify the output mesh.

The output of the invention may thus comprise a computational model of geometry to be analysed, e.g. for flow rates, velocities, pressure, stress/strain, deformation, or any other engineering parameter that may vary in use. The generation of an improved geometry model or mesh may thus improve the engineering modelling/analysis process, by altering the accuracy of modelling one or more engineering parameter and/or altering processing cost/efficiency.

The engineering modelling process comprises the definition of one or more boundary condition at the extremity of the region of interest, e.g. an inlet, outlet, fluid/solid interface, wall or an edge of the domain. With known boundary conditions, the relevant engineering modelling algorithms can be applied over each cell/element of the mesh in order to reach an engineering model solution for the domain as a whole.

To the inventors' knowledge, this disclosure is the first instance a general-purpose optimization approach used for blocking such that blocking and mesh generation can be automated to a far greater extent across a variety of scenarios and applications. Examples of variations to the above described process include:

- The operators applied within the evolutionary algorithm have been adapted in this proposal to improve performance and other variants of the selection/mutation/crossover operator are possible.
- The pool of candidate solutions can be augmented by making use of existing heuristics to add to the list of candidate interior and exterior points.

• Alternative methods can also be used to convert the set of interior and exterior points into a blocking solution

Whilst the above description has focussed primarily on CFD meshing, it will be appreciated to the skilled person that the techniques applied herein could also be applied to FEA meshing and modelling.

Apart from the technical innovations that have been described above, some key potential points of novelty include:

- A quantitative as opposed qualitative approach to blocking which will lead to better consistency and reliability
- Breaking down of the problem into two sub-problems, namely 1) the evolutionary algorithm that optimizes the selection of exterior and interior points and 2) a series of computational geometry operators create a blocking solution that uses the points selected by the evolutionary algorithm.

In any aspect of the invention, the modelling methods, tools described herein may be used as part of a product refinement/improvement or product generation/manufacturing method/system. That is to say a proposed product can be modelled and its design assessed for suitability by engineering analysis. The proposed product may then be modified or improved by altering the product geometry in the product model and the revised product model may be blocked/meshed and modelled. This may be repeated as often as necessary until a final design/geometry for the product is achieved which meets the engineering analysis requirements. The final design may thus be taken forward to production, either for production of one or more prototype, e.g. for testing and/or manufacturing/production in larger product quantities.

**Claims**

1. A computational engineering modelling tool (10) comprising:

   a point generation module (12) arranged to read geometry data representing a domain (24) to be modelled and to generate point data for said domain comprising a plurality of boundary points (26) located on a boundary of the domain and a plurality of further points (28) spaced from the boundary within the domain;
   a point mutation module(14) arranged to process the point generation module output and to generate automatically a plurality of alternative point data definitions for said domain in which the location of at least one point differs between each of said alternative point definitions, and
   a blocking module (16) arranged to discretize said domain(24) by creating multiple geometric blocks over said domain using a computational geometric operator such that each point represents a vertex of at least one block, the blocking module outputting a discretized computational model of said domain,

   wherein the tool scores the discretized computational model according to a geometric attribute of the blocks.

2. A modelling tool according to claim 1, wherein the discretized computation model of said domain may comprise a mesh in which each point is connected to a plurality of adjacent points and the geometric blocks each represent an enclosed element or cell of the mesh.

3. A modelling tool according to any preceding claim, wherein a plurality of candidate discretized computational models are output by the blocking module for a single domain and the tool selects a candidate model for engineering analysis of the model in dependence on its score.

4. A modelling tool according to any preceding claim, wherein the tool further scores each of the plurality of alternative point data definitions and selects or rejects each point data definition as a candidate point data definition in dependence thereon.

5. A modelling tool according to claim 3 or 4, wherein the point mutation module operates according to an iterative procedure in which the point mutation module selects at each iteration one of the plurality of alternative candidate point data definitions or one of the corresponding candidate models and modifies one or more point therein before re-scoring the associated modified computational model and either retaining or rejecting said modified computational model as a new candidate based on a comparison of its score with the score of existing candidate computational models.

6. A modelling tool according to any preceding claim, wherein the point generation module identifies a plurality of sections of the domain boundary, each section comprising a straight or curved edge and the point generation module divides said sections by inserting one or more point at a location part way along said sections according to a plurality of section geometry assessment algorithms.

7. A modelling tool according to claim 6, wherein the point generation module inserts a point at a location where a section is found to meet one or more of the following criteria:

the section creates an acute angle in the boundary; a curvature value of the section is greater than a threshold value and/or a perpendicular component of the distance between a pair of existing points on the boundary exceeds a threshold value relative to another pair of existing points.

8. A modelling tool according to any preceding claim, wherein the point generation module inserts one or more points according to a location at which a trajectory of a ray emanating from an existing point intersects a location on the boundary.

9. A modelling tool according to claim 8, wherein the point generation module inserts a boundary point at the location where a ray meets a location on the boundary and/or inserts a further point spaced from the boundary at a location part way along the ray trajectory.

10. A modelling tool according to any preceding claim, wherein the point mutation module adds and/or removes one or more point from the point data output by the point generation module according to a plurality of different point mutation schemes.

11. A modelling tool according to any preceding claim, wherein the point mutation module assesses a geometric attribute of the blocks created for the domain by the blocking module for a point data set and adds or removes a point from one or more block according to said attribute.

12. A modelling tool according to any preceding claim, wherein the point mutation module applies a random mutation scheme by undertaking one or more of: randomly selecting one or more of the alternative point data definitions for point mutation; selecting mutation scheme to apply at random from a list of possible mutation schemes; and/or by random selection of a point to insert/delete within one of the alternative point data definitions.

13. A modelling tool according to any preceding claim, wherein the blocking module comprises a triangulation algorithm in which triangular blocks are formed, for which each point represents a vertex of each triangle and a geometric block merging algorithm for merging adjacent triangular blocks so as to form a computational model comprising quadrilateral blocks.

14. A computational engineering modelling method comprising:

reading into a computer memory geometry data representing a domain to be modelled and generating point data for said domain comprising a plurality of boundary points located on a boundary of the domain and a plurality of further points spaced from the boundary within the domain;
mutating the generated point data by processing the generated point data so as to create a plurality of alternative point data definitions for said domain in which the location of at least one point differs between each of said alternative point definitions, and
discretizing said domain by creating multiple geometric blocks over said domain using a computational geometric operator such that each point of the point data represents a vertex of at least one block, and outputting a discretized computational model of said domain,

wherein the method comprises scoring the discretized computational model according to a geometric attribute of the blocks and selecting one of the alternative point data definitions for implementation according to the score for the discretized computational model.

15. A data carrier comprising machine readable instructions for operation of one or more processor to provide a computational engineering modelling tool by:

executing a point generation module arranged to read geometry data representing a domain to be modelled and to generate point data for said domain comprising a plurality of boundary points located on a boundary of the domain and a plurality of further points spaced from the boundary within the domain;

executing a point mutation module arranged to process the point generation module output and to generate automatically a plurality of alternative point data definitions for said domain in which the location of at least one point differs between each of said alternative point definitions, and

executing a blocking module arranged to discretize said domain by creating multiple geometric blocks over said domain using a computational geometric operator such that each point represents a vertex of at least one block, the blocking module outputting a discretized computational model of said domain,

wherein the machine readable instructions control scoring of the discretized computational model according to a geometric attribute of the blocks.

FIG. 1

Pre-Processing Stage

Set of all possible exterior points

Set of all possible interior points

Start of Evolutionary Algorithm

Initialize population of size *P* with random subset of exterior and interior points each

All solutions after quad-blocked are added to the archive. The archive then performs a Pareto sorting within.

Quad Blocking

Repeat for a number of *G* number of generations

A percentage of the best solution are added back to the population (elitism)

Pareto Ranking/Sorting

Archive Storage

Targeted Mutation

Quad Blocking

Roulette Wheel Selection

Any better solution found thru targeted mutation is added to Archive Storage

Crossover

Random Mutation

FIG. 2

FIG. 3A          FIG. 3B          FIG. 3C

FIG. 4A          FIG. 4B

S1

**FIG. 5A**

S2

**FIG. 5B**

$EP^{S1}{}_A$

$IP^{S1}{}_A$

$IP^{S1}{}_B$

$EP^{S1}{}_B$

**FIG. 5C**

$EP^{S2}{}_A$

$IP^{S2}{}_A$

$IP^{S2}{}_B$

$EP^{S2}{}_B$

**FIG. 5D**

C1

**FIG. 5E**

C2

**FIG. 5F**

FIG. 6

FIG. 7

FIG. 8

Europäisches
Patentamt

European
Patent Office

Office européen
des brevets

# EUROPEAN SEARCH REPORT

Application Number

EP 16 17 8091

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JEREMY P. DITTMER ET AL: "Mesh Optimization Using a Genetic Algorithm to Control Mesh Creation Parameters", COMPUTER-AIDED DESIGN AND APPLICATIONS, vol. 3, no. 6, 2006, pages 731-740, XP055324627, DOI: 10.1080/16864360.2006.10738426 * abstract; sections 4 & 5 * ----- | 1-15 | INV. G06T17/20 |

TECHNICAL FIELDS
SEARCHED    (IPC)

G06T

The present search report has been drawn up for all claims

| Place of search | Date of completion of the search | Examiner |
|---|---|---|
| Munich | 30 November 2016 | Picallo Gonzalez, C |

EPO FORM 1503 03.82 (P04C01)